Europäisches Patentamt

European Patent Office

Office européen des brevets

(19)

(11) EP 0 795 910 A1

(12) DEMANDE DE BREVET EUROPEEN

(43) Date de publication:
17.09.1997 Bulletin 1997/38

(51) Int Cl.⁶: H01L 27/15

(21) Numéro de dépôt: 97400528.2

(22) Date de dépôt: 10.03.1997

(84) Etats contractants désignés:
DE GB

(30) Priorité: 12.03.1996 FR 9603080

(71) Demandeur: FRANCE TELECOM
75015 Paris (FR)

(72) Inventeurs:
• Nakajima, Hisao
  92220 Bagneux (FR)

• Charil, Josette
  92190 Meudon (FR)

(74) Mandataire: Dubois-Chabert, Guy et al
Société de Protection des Inventions
25, rue de Ponthieu
75008 Paris (FR)

(54) **Dispositif semiconducteur d'émission-réception à faible diaphotie**

(57)     Ce dispositif comprend un substrat semiconducteur (90) sur lequel sont intégrés de façon monolithique : un premier composant (92) émettant une lumière modulée de longueur d'onde λ1, un deuxième composant (94) détectant une lumière modulée de longueur d'onde λ2>λ1, et au moins un troisième composant (96) séparant les précédents et absorbant la lumière de longueur d'onde λ1 sans absorber celle de longueur d'onde λ2, Au moins l'un des composants est conçu pour réduire la diaphotie se produisant au niveau du deuxième composant et due à la lumière modulée de longueur d'onde λ1. Application aux télécommunications optiques.

## FIG.4

EP 0 795 910 A1

## Description

### DOMAINE TECHNIQUE

La présente invention concerne un dispositif semiconducteur d'émission-réception.

Elle s'applique notamment aux télécommunications optiques et plus particulièrement aux réseaux de distribution optiques interactifs, le dispositif étant alors installé chez les abonnés.

L'invention permet entre autres la réalisation de duplexeur fonctionnant à 1,3 μm et à 1,55 μm,

### ÉTAT DE LA TECHNIQUE ANTÉRIEURE

Les dispositifs d'émission-réception permettant simultanément l'émission et la réception de signaux optiques sont très importants pour les réseaux de distribution optique, notamment pour les extrémités de tels réseaux en lesquelles on place de tels dispositifs d'émission-réception.

On utilise communément une longueur d'onde pour l'émission et une autre longueur d'onde pour la réception.

On utilise par exemple les longueurs d'onde valant respectivement 1,3 μm et 1,5 μm.

On peut aussi utiliser une longueur d'onde légèrement inférieure à 1,3 3 μm tandis que l'autre longueur d'onde est légèrement supérieure à 1,3 μm.

Les dispositifs connus d'émission-réception comportent au moins un émetteur de lumière et une photodiode (détecteur de lumière), un diviseur optique ainsi que des moyens électroniques associés à ces composants.

L'intégration de tels composants sous la forme d'un composant unique " photonique " permet la simplification de la fabrication des dispositifs tout en diminuant leur coût.

En effet, le coût d'assemblage des composants contribue de façon importante au prix de revient de ces dispositifs d'émission-réception.

Deux types d'intégration peuvent être envisagés.

Un premier type d'intégration est fondé sur le principe de la réalisation de composants discrets (photodiode, émetteur laser et guide optique) sur un substrat.

A ce sujet, on se reportera au document (1) qui, comme les autres documents cités par la suite, est mentionné à la fin de la présente description.

Ce premier type d'intégration nécessite la mise en oeuvre d'une technologie complexe et très coûteuse.

En revanche, elle est généralement performante du fait que les composants utilisés peuvent être optimisés individuellement.

D'une manière générale, les dimensions du dispositif obtenu sont relativement grandes (de l'ordre de 3,5 mm x 0,6 mm) à cause d'un coupleur optique intégré que le dispositif comprend.

Un deuxième type d'intégration consiste en une intégration " photonique " réalisée à partir d'une structure laser, structure que l'on appelle souvent " structure en ligne " (" *in line structure* ") parce qu'un laser et une photodiode sont alignés suivant une ligne de propagation de signaux optiques.

A ce sujet, on se reportera au document (2) qui décrit des dispositifs d'émission-réception fondés sur une structure du type à réflecteur de Bragg distribué (" *distributed Bragg reflector* ").

Dans ce document (2), deux dispositifs sont mentionnés, l'un fonctionnant en tant qu'émetteur à 1,3 μm et en tant que récepteur à 1,5 μm et inversement pour l'autre.

Pour le dispositif émettant à 1,5 μm et recevant à 1,3 μm, une sensibilité (BER, pour *"Bit Error Rate",* égal à $10^{-9}$) en réception à 1,3 μm égale à -20 dBm (mais seulement à -17,1 dBm en mode émission-réception simultanées) a été obtenue à 155 Mb/s.

Les performances du dispositif émettant à 1,3 μm et recevant à 1,5 μm ne sont pas mentionnées dans ce document (2).

La technique de l'intégration de composants photoniques sur un substrat est conceptuellement la plus simple.

Cependant, elle est très difficile à mettre en oeuvre et très coûteuse à cause de sa complexité.

Elle nécessite en effet la combinaison de plusieurs technologies différentes.

De plus, étant donné les dimensions non négligeables (quelques millimètres carrés) des dispositifs réalisés conformément à cette technique connue, le nombre de tels dispositifs réalisables sur un même substrat est faible.

Un dispositif à structure en ligne nécessite, quant à lui, des technologies homogènes pour la fabrication de toutes les parties de ce dispositif.

En conséquence, un tel dispositif est plus facile à fabriquer et a des coûts de fabrication moins élevés.

Cependant, les performances de ce dispositif ne sont pas très élevées.

Ceci résulte des compromis nécessaires en vue de simplifier la réalisation d'un tel dispositif.

De plus, ces performances sont déterminées par l'isolation tant électrique qu'optique.

En particulier, pour un dispositif émettant des signaux à 1,3 μm et détectant des signaux à 1,5 μm, la perturbation optique, que l'on appelle " diaphotie " et qui provient d'un laser dont la longueur d'onde vaut 1,3 μm, est déterminante pour la réception des signaux à 1,5 μm du fait que le récepteur de ces derniers signaux est également sensible à 1,3 μm.

Ce type d'inconvénient est inhérent à la structure en ligne du dispositif.

Un troisième type de dispositif semiconducteur d'émission-réception fonctionnant à deux longueurs d'onde λ1 et λ2, par exemple 1,3 μm et 1,5 μm est également réalisable.

Ce dispositif comprend un substrat semiconducteur sur lequel sont intégrés de façon monolithique :

- un premier composant semiconducteur (laser par exemple de type à réflecteur de Bragg distribué) constituant la "section laser" du dispositif et apte à émettre à la longueur d'onde λ1 (1,3 μm),
- un deuxième composant semiconducteur formant un photorécepteur à la longueur d'onde λ2 (1,5 μm) et constituant la "section photoréceptrice" du dispositif, et
- au moins un composant semiconducteur intermédiaire, placé entre la section laser et la section photoréceptrice.

Ce composant intermédiaire est apte à absorber la lumière de longueur d'onde λ1 sans absorber la lumière de longueur d'onde λ2 lorsqu'il est polarisé de façon inverse ou sans polarisation.

Ce composant intermédiaire constitue la "section absorbante" du dispositif.

Son pouvoir d'absorption est renforcé lorsqu'il est polarisé en inverse.

Cette section absorbante permet de réduire la diaphotie qui est due au fonctionnement du laser à la longueur d'onde λ1 et qui perturbe la réception de signaux optiques à la longueur d'onde λ2 par le photorécepteur.

On a réalisé un dispositif du troisième type dont la sensibilité vaut -13,8 dBm à 196 Mb/s pour la réception à 1,554 μm, avec une émission à 1,3 μm au débit de 155 Mb/s et dont les dimensions ne dépassent pas 1 mm x 0,5 mm et sont donc inférieures à celles des dispositifs mentionnés dans le document (1).

En ce qui concerne ce troisième type de dispositif, les auteurs de la présente invention ont constaté que la diaphotie provenait de la modulation du laser émettant à la longueur d'onde λ1 (1,3 μm dans l'exemple considéré).

Plus précisément, ils ont constaté que la diaphotie était due à la lumière modulée de longueur d'onde λ1 et non pas à la lumière non-modulée de longueur d'onde λ1.

**EXPOSÉ DE L'INVENTION**

La présente invention a pour objet un dispositif semiconducteur d'émission-réception à deux longueurs d'onde différentes, ce dispositif ayant une diaphotie inférieure à celle du dispositif du troisième type mentionné ci-dessus.

De façon précise, la présente invention a pour objet un dispositif semiconducteur d'émission-réception de signaux optiques modulés, ce dispositif étant caractérisé en ce qu'il comprend un substrat semiconducteur sur lequel sont intégrés de façon monolithique :

- un premier composant semiconducteur ayant une couche active à la longueur d'onde λ1, ce premier composant étant apte à émettre une lumière modulée de longueur d'onde λ1,
- un deuxième composant semiconducteur ayant une couche active à une longueur d'onde λ2, cette longueur d'onde λ2 étant supérieure à la longueur d'onde λ1, ce deuxième composant étant apte à détecter une lumière modulée de longueur d'onde λ2, et
- au moins un troisième composant semiconducteur qui sépare les premier et deuxième composants l'un de l'autre et qui est apte à absorber la lumière de longueur d'onde λ1 sans absorber la lumière de longueur d'onde λ2,

et en ce qu'au moins l'un des premier, deuxième et troisième composants est conçu pour réduire la diaphotie qui se produit au niveau du deuxième composant et qui est due à la lumière modulée de longueur d'onde λ1 provenant du premier composant.

Selon un premier mode de réalisation particulier du dispositif objet de l'invention, le premier composant comprend :

- un laser qui est apte à émettre une lumière de longueur d'onde λ1 et d'intensité constante, et
- un moyen de modulation de la lumière de longueur d'onde λ1 émise par le laser, ce laser étant placé entre ce moyen de modulation et le troisième composant.

Le laser apte à émettre la lumière de longueur d'onde λ1 et d'intensité constante peut être un laser à contre-réaction distribuée.

Le moyen de modulation de lumière peut être un modulateur d'intensité qui est électro-absorbant à la longueur d'onde λ1.

De préférence, le troisième composant comprend une couche absorbant la lumière dont la largeur de bande interdite ("*bandgap*") est comprise entre la largeur de bande interdite de la couche active du premier composant et la largeur de bande interdite de la couche active du deuxième composant.

Selon un deuxième mode de réalisation particulier du dispositif objet de l'invention, le dispositif comprend en outre, au moins au niveau du deuxième composant, une couche absorbante supplémentaire, apte à absorber la lumière de longueur d'onde λ1.

Dans ce cas, selon un mode de réalisation particulier, la couche active à la longueur d'onde λ1 du premier composant se prolonge dans le troisième composant et dans le deuxième composant, le dispositif comprend en outre une couche de confinement de lumière qui s'étend le long de cette couche active à la longueur d'onde λ1 et qui, dans le deuxième composant, est comprise entre cette couche active à la longueur d'onde λ1 et la couche active à la longueur d'onde λ2, et la couche absorbante supplémentaire se trouve, dans le deuxième composant, entre la couche de confinement et la couche active à la longueur d'onde λ2.

La couche absorbante supplémentaire peut se prolonger dans le troisième composant.

De préférence, la largeur de bande interdite de la couche absorbante supplémentaire est comprise entre la largeur de bande interdite de la couche active à la longueur d'onde λ1 et la largeur de bande interdite de la couche active à la longueur d'onde λ2.

Selon un troisième mode de réalisation particulier du dispositif objet de l'invention, les premier et troisième composants sont munis de moyens de commande prévus pour appliquer au premier composant des premiers signaux électriques permettant la production de la lumière modulée à la longueur d'onde λ1 et pour appliquer au troisième composant des deuxièmes signaux électriques qui sont complémentaires des premiers signaux électriques, de façon que la modulation du premier composant par les premiers signaux électriques et la modulation du troisième composant par les deuxièmes signaux électriques se fassent en opposition de phase.

Dans un mode de réalisation particulier de l'invention, la longueur d'onde λ1 vaut 1,3 μm et la longueur d'onde λ2 vaut 1,5 μm.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

* la figure 1 est une vue en coupe longitudinale schématique d'un exemple du dispositif du troisième type mentionné plus haut, comprenant deux composants à contre-réaction distribuée (" *distributed feedback* "), séparés par deux composants intermédiaires,
* la figure 2 est une vue en coupe longitudinale schématique d'un autre exemple du dispositif du troisième type, comprenant un composant à contre-réaction distribuée, un autre composant à cavité de Fabry-Pérot et un composant intermédiaire,
* la figure 3 est une vue en coupe transversale du dispositif représenté sur la figure 2,
* la figure 4 est une vue en coupe longitudinale schématique d'un premier mode de réalisation particulier du dispositif objet de la présente invention, comprenant deux sections absorbantes,
* la figure 5 est une vue en coupe longitudinale schématique d'un deuxième mode de réalisation particulier du dispositif objet de la présente invention, qui utilise une couche absorbante supplémentaire par rapport à un dispositif du genre de celui de la figure 2,
* la figure 6 est une vue en coupe longitudinale schématique d'un dispositif conforme à l'invention, qui forme un duplexeur 1,3 μm - 1,5 μm et qui intègre un modulateur électro-absorbant à 1,3 μm, et

* la figure 7 est une vue en coupe longitudinale schématique d'un troisième mode de réalisation particulier du dispositif objet de la présente invention, utilisant des signaux de commande complémentaires.

## EXPOSÉ DÉTAILLÉ DE MODES DE RÉALISATION PARTICULIERS

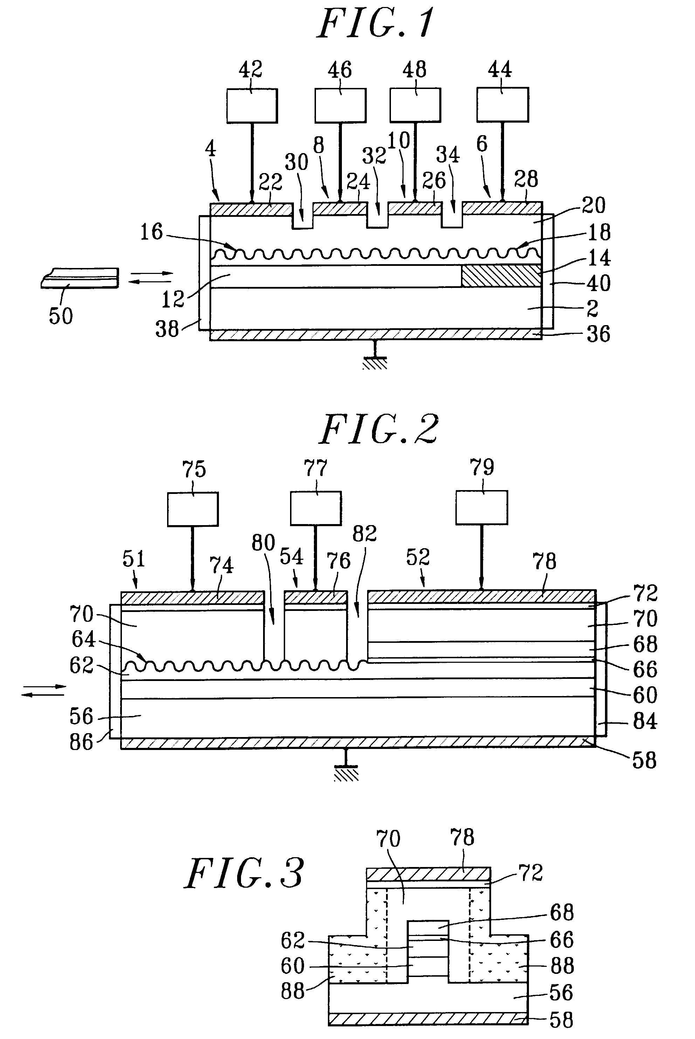

Le dispositif du troisième type, qui est schématiquement représenté sur la figure 1, comprend un substrat semiconducteur 2 sur lequel sont intégrés de façon monolithique :

- un premier composant semiconducteur 4,
- un deuxième composant semiconducteur 6, et
- deux composants intermédiaires 8 et 10 qui sont placés entre les composants 4 et 6.

Plus précisément, le dispositif de la figure 1 comprend, sur le substrat 2 par exemple InP dopé N, une couche active à la longueur d'onde 1,3 μm, référencée 12, qui est commune aux composants 4, 8 et 10, ainsi qu'une autre couche active à la longueur d'onde 1,5 μm, référencée 14, qui s'étend dans le composant 6 et prolonge la couche active 12 comme on le voit sur la figure 1.

Un réseau de Bragg 16, dont la longueur d'onde de Bragg vaut 1,3 μm, s'étend au-dessus de la couche active 12.

Ce réseau 16 est prolongé par un autre réseau de Bragg 18, dont la longueur d'onde de Bragg vaut 1,5 μm et qui s'étend, quant à lui, au-dessus de la couche active 14.

Ces réseaux 16 et 18 sont recouverts par une couche 20 par exemple en InP dopé P.

Cette couche 20 est recouverte par des couches conductrices 22, 24, 26 et 28 respectivement au niveau des composants 4, 8, 10 et 6.

Des zones 30, 32 et 34 sont gravées à partir de la face supérieure du dispositif de la figure 1 à travers ces couches conductrices et jusque dans la couche 20 pour assurer l'isolation électrique des couches 22, 24, 26 et 28 les unes par rapport aux autres, comme on le voit sur la figure 1.

La face inférieure du dispositif, c'est-à-dire la face inférieure du substrat 2, est recouverte d'une couche conductrice 36 mise à la masse.

La face-avant du dispositif, qui est située du côté de la couche 12, est recouverte d'une couche anti-reflet 38.

La face-arrière du dispositif, qui est située du côté de la couche 14, est quant à elle recouverte d'une couche de haute réflectivité 40.

Des moyens de polarisation 42, 44, 46 et 48 sont prévus pour polariser respectivement les couches conductrices 22, 28, 24 et 26.

On peut ainsi définir plusieurs sections dans le dispositif de la figure 1, à savoir :

- une section " active " à 1,3 μm qui correspond au composant 4,
- une section " active " à 1,5 μm qui correspond au composant 6, et
- deux sections absorbantes qui correspondent aux composants 8 et 10.

Le composant 4 est polarisé de façon directe par les moyens de polarisation correspondants 42 et forme ainsi un laser à contre-réaction distribuée émettant à 1,3 μm.

Le composant 6 est polarisé de façon inverse (ou nulle) par les moyens de polarisation correspondants 44 et forme ainsi une photodiode détectant une lumière de longueur d'onde 1,5 μm.

Les moyens 46 et 48 sont, quant à eux, prévus pour polariser les composants 8 et 10 de façon inverse, de manière à absorber la lumière de longueur d'onde 1,3 μm se propageant dans la partie centrale du dispositif, tout en évitant l'absorption de la lumière de longueur d'onde 1,5 μm, et constituent donc des photodiodes détectant la lumière de longueur d'onde 1,3 μm.

Les sections absorbantes se comportent comme des filtres optiques qui bloquent les longueurs d'onde inférieures ou égales à 1,3 μm.

Les sections absorbantes permettent donc les séparations électrique et optique des sections actives à 1,3 μm et 1,5 μm.

Le dispositif de la figure 1 est, on l'a vu, capable d'émettre des signaux optiques à 1,3 μm et de détecter des signaux optiques à 1,5 μm.

L'émission et la réception de ces signaux se fait par la face-avant du dispositif, où se trouve la couche anti-reflet 38.

L'émission et la réception des signaux optiques s'effectuent donc à partir d'une seule entrée et, par conséquent, le dispositif ne nécessite qu'une seule fibre optique de liaison 50.

La figure 2 est une vue schématique d'un autre exemple de dispositif du troisième type, constituant un duplexeur 1,3 μm - 1,5 μm en ligne.

Ce dispositif est fondé sur une structure à ruban enterré (" buried ridge structure ").

A ce sujet, on se reportera au document (3).

Le dispositif de la figure 2 comprend une section active à 1,3 μm référencée 51, une section active à 1,5 μm référencée 52 et, entre ces deux sections, une section absorbante 54.

Grâce à des polarisations appropriées, la section 51 forme un laser émettant à 1,3 μm et la section 52 forme une photodiode détectant des signaux optiques à 1,5 μm.

La section absorbante 54 est, quant à elle, prévue pour absorber la lumière de longueur d'onde 1,3 μm.

Le dispositif de la figure 2 comprend plus précisément un substrat 56 en InP dopé N sur la face inférieure duquel se trouve une couche conductrice 58 mise à la masse.

La face supérieure du substrat 56 est recouverte par une couche 60 en InGaAsP dont la largeur de bande interdite correspond à 1,3 μm.

Cette couche 60 est recouverte d'une couche 62 en InGaAsP dont la largeur de bande interdite correspond à 1,18 μm.

Un réseau de diffraction 64, dont la longueur d'onde de Bragg vaut 1,3 μm, s'étend dans les sections 51 et 54, au-dessus de cette couche 62, comme on le voit sur la figure 2.

Dans la section 52, la couche 62 est recouverte par une mince couche 66 en InP.

Cette couche 66 est recouverte par une couche 68 en InGaAsP de largeur de bande interdite correspondant à 1,5 μm.

Une couche 70 en InP dopé P recouvre le réseau 64 et la couche 68.

Cette couche 70 est elle-même recouverte par une couche de contact 72.

Des électrodes 74, 76 et 78 recouvrent cette couche 72 respectivement dans les zones 51, 54 et 52 et sont reliées à des moyens 75, 77 et 79 de polarisation des sections correspondantes.

Des zones gravées 80 et 82 permettent la séparation électrique de ces électrodes 74, 76 et 78 et s'étendent jusqu'au réseau 64 à travers les couches 72 et 70, comme on le voit sur la figure 2.

A titre purement indicatif et nullement limitatif, les longueurs des sections 51, 54 et 52 valent respectivement 200 μm, 80 μm et 350 μm.

La face-arrière du dispositif de la figure 2, qui est située du côté de la couche 68, est recouverte d'une couche de haute réflectivité 84.

La face-avant du dispositif, qui est située du côté du réseau 64, est recouverte d'une couche anti-reflet 86.

Les signaux à détecter par le dispositif sont envoyés vers cette face-avant et les signaux optiques émis par le dispositif sortent de celui-ci par la couche 86.

La lumière issue de la couche 68 est couplée d'une façon évanescente au guide de lumière de 1,3 μm (couche 60) qui est transparent à 1,5 μm.

Le réseau 64 a un pas de 200 nm et il est gravé dans la couche 62 et rétrodiffuse la lumière de longueur d'onde 1,3 μm.

De ce fait, la section 51, qui est polarisée de façon directe, forme un laser à contre-réaction distribuée émettant à 1,3 μm.

Il est préférable que le coefficient de couplage du réseau 64 soit très élevé (supérieur à 200 cm$^{-1}$).

Cela permet de réaliser une structure à contre-réaction distribuée courte.

Lorsque la section absorbante 54 est polarisée de façon inverse, la lumière de longueur d'onde 1,3 μm y est très fortement absorbée.

La présence du réseau 64 dans cette section 54 renforce cet effet du fait de la réflexion de Bragg.

On précise que la séparation électrique des électrodes 74, 76 et 78 est réalisée par une combinaison d'une gravure sèche de type gravure par faisceau d'ions réactifs (" *reactive ion beam etching* ") et d'une attaque chimique.

Une gravure profonde jusqu'à la couche 62 permet d'obtenir une résistance électrique de séparation de 50 kΩ.

On notera que la section 52, qui est polarisée de façon inverse, constitue un photodétecteur à cavité de Fabry-Pérot.

La figure 3 est une vue en coupe transversale schématique du dispositif de la figure 2 au niveau de la section 52.

On voit qu'on a réalisé une implantation de protons dans les deux zones 88 se trouvant de part et d'autre du ruban formé à partir de l'empilement des couches 60, 62, 66, 68.

Cela permet de diminuer le courant de fuite traversant les homojonctions latérales et la capacité parasite de la structure.

Une capacité de 4 pF/100 μm et un courant de fuite inférieur à 1 μA ont été obtenu à -1 V.

Avec le dispositif de la figure 2, on a obtenu un coefficient de détection (pente de la courbe des variations du photo-courant en fonction de la puissance optique d'entrée) de 0,32 A/W à 1,3 μm et de 0,26 A/W à 1,5 μm.

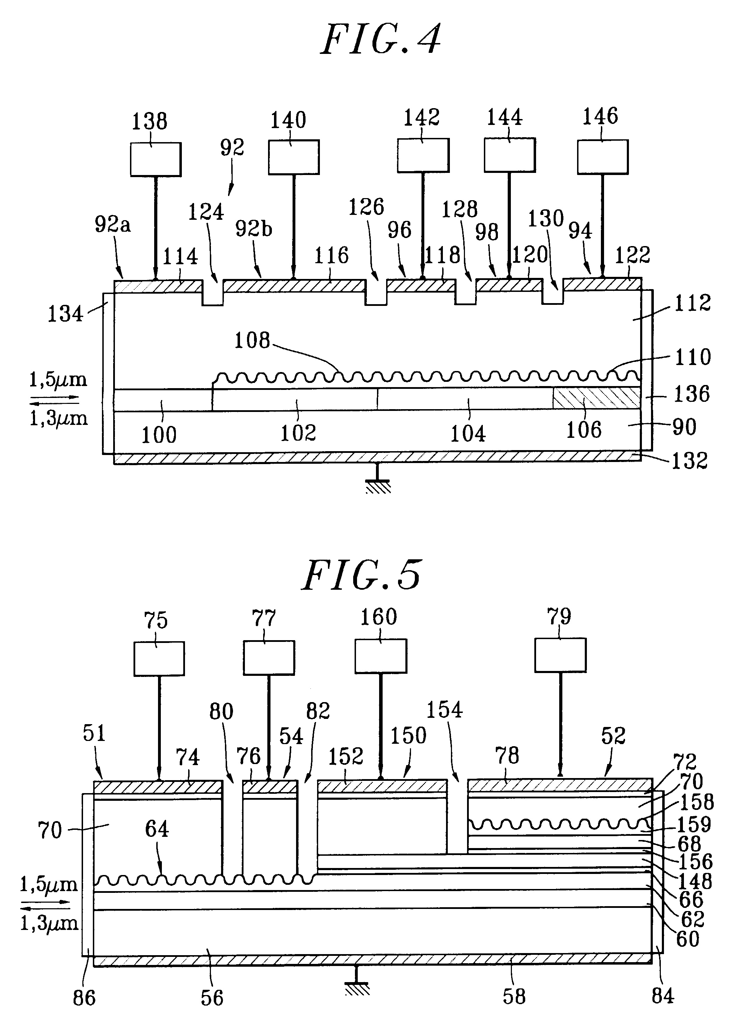

Le dispositif conforme à l'invention, qui est schématiquement représenté sur la figure 4, est un duplexeur 1,3μm - 1,5 μm.

Ce dispositif de la figure 4 est, comme ceux des figures 5 à 7, conçu pour réduire fortement la diaphotie qui se produit au niveau de la section de détection à 1,5 μm et qui est due à la lumière modulée de longueur d'onde 1,3 μm provenant de la section d'émission du dispositif.

Pour ce faire, dans le cas du dispositif de la figure 4, qui est une amélioration du dispositif de la figure 1, on réduit très fortement la quantité de lumière modulée à 1,3 μm (ou signaux optiques modulés à 1,3 μm) atteignant la section de détection à 1,5 μm.

Dans ce dispositif de la figure 4, le moyen pour réduire la quantité de signaux optiques modulés à 1,3 μm qui se propagent vers la section de détection à 1,5 μm consiste à utiliser une section d'émission de signaux modulés à 1,3 μm en deux parties, à savoir une partie qui émet une lumière non-modulée, de longueur d'onde 1,3 μm, et une partie qui module cette lumière, comme on va le voir dans ce qui suit.

Le dispositif de la figure 4 comprend un substrat semi-conducteur 90 sur lequel sont intégrés de façon monolithique :

- un premier composant semiconducteur qui est destiné à émettre des signaux optiques modulés à 1,3 μm et qui est référencé 92,
- un deuxième composant semiconducteur 94 destiné à la réception de signaux optiques modulés à 1,5 μm, et

- deux troisièmes composants semiconducteurs 96 et 98 qui sont placés entre les composants 92 et 94.

Le composant 92 est subdivisé en deux sous-composants 92a et 92b.

Le sous-composant 92b est compris entre le sous-composant 92a et le composant 96 et le composant 98 est compris entre ce composant 96 et le composant 94.

Plus précisément, le dispositif de la figure 4 comprend, sur le substrat 90, une couche modulante 100 prolongée par une couche 102 active à la longueur d'onde 1,3 μm.

Cette couche 102 est prolongée par une couche 104 apte à absorber la lumière de longueur d'onde 1,3 μm, elle-même prolongée par une couche 106 active à la longueur d'onde 1,5 μm, comme on le voit sur la figure 4.

Un réseau de Bragg 108, dont la longueur d'onde de Bragg vaut 1,3 μm, s'étend au-dessus des couches 102 et 104.

Ce réseau 108 est prolongé par un autre réseau de Bragg 110, dont la longueur d'onde de Bragg vaut 1,5 μm et qui s'étend, quant à lui, au-dessus de la couche active 106.

Ces réseaux 108 et 110 sont recouverts par une couche 112 qui recouvre également la couche 100.

Cette couche 112 est recouverte par des couches conductrices 114, 116, 118, 120 et 122 respectivement au niveau des composants 92a, 92b, 96, 98 et 94.

Des zones 124, 126, 128 et 130 sont gravées à partir de la surface supérieure du dispositif de la figure 4 à travers ces couches conductrices et jusque dans la couche 112 pour assurer l'isolation électrique des couches 114, 116, 118, 120 et 122 les unes par rapport aux autres, comme on le voit sur la figure 4.

La face inférieure du dispositif, c'est-à-dire la face inférieure du substrat 90, est recouverte d'une couche conductrice 132 mise à la masse.

La face-avant du dispositif, qui est située du côté de la couche 100, est recouverte d'une couche anti-reflet 134.

La face-arrière du dispositif, qui est située du côté de la couche 106, est, quant à elle, recouverte d'une couche de haute réflectivité 136 mais ce n'est pas indispensable.

Des moyens de polarisation 138, 140, 142, 144 et 146 sont prévus pour polariser respectivement les couches conductrices 114, 116, 118, 120 et 122.

Le composant 92a constitue un modulateur d'intensité qui est électro-absorbant à 1,3 μm.

Le composant 92b constitue un laser à contre-réaction distribuée émettant à 1,3 μm.

Les composants 96 et 98 sont des sections absorbantes à 1,3 μm.

Des moyens de polarisation 138, 140, 142, 144 et 146 sont prévus pour polariser respectivement les électrodes 114, 116, 118, 120 et 122.

Les moyens 138 sont prévus pour appliquer une tension négative de modulation au modulateur 92a.

Les moyens 142 et 144 sont prévus pour appliquer des tensions négatives respectivement aux composants 96 et 98, pour polariser ceux-ci en inverse.

Les moyens 140 sont prévus pour envoyer au laser 92b un courant de polarisation permettant à ce laser d'émettre en continu à la longueur d'onde 1,3 μm.

La lumière à 1,3 μm ainsi émise est modulée par le modulateur 92a qui fournit les signaux modulés de longueur d'onde 1,3 μm.

Les moyens 146 sont prévus pour polariser de façon inverse le composant 94 qui constitue une photodiode détectant les signaux optiques modulés à 1,5 μm.

L'émission des signaux optiques modulés à 1,3 μm et la réception des signaux optiques modulés à 1,5 μm se fait par la face-avant du dispositif où se trouve la couche anti-reflet 134.

Comme dans le cas de la figure 1, l'émission et la réception des signaux optiques s'effectuent donc à partir d'une seule entrée et, par conséquent, le dispositif de la figure 4 ne nécessite, comme le dispositif de la figure 1, qu'une seule fibre optique de liaison (non représentée).

La lumière du laser 92b est, comme on l'a vu, modulée par le modulateur 92a et l'on évite la propagation de lumière modulée à 1,3 μm vers le photodétecteur 94 qui détecte la lumière de longueur d'onde 1,5 μm.

En effet, le modulateur 92a ne module que la lumière traversant sa couche modulante 100.

Bien qu'une lumière d'intensité continue et de longueur d'onde 1,3 μm se propage vers la section de photodétection à 1,5 μm référencée 94, il n'y a quasiment plus de diaphotie.

En pratique, des "fuites" de signaux optiques modulés à 1,3 μm sont susceptibles de se produire en direction du photodétecteur 94.

Les sections absorbantes 96 et 98 permettent d'absorber ces signaux de fuite.

La couche modulante 100 du modulateur 92a est faite avec un matériau semiconducteur dont la largeur de bande interdite est légèrement plus grande que la largeur de bande interdite de la couche active 102 du laser 92b émettant à 1,3 μm.

Toutefois, il est possible d'utiliser une couche modulante 100 ayant la même composition que celle de la couche active 102 de ce laser 92b et de faire fonctionner celui-ci sans avoir trop d'absorption dans la couche modulante 100, à condition de décaler légèrement la longueur d'onde d'émission du laser 92b vers les grandes longueurs d'onde (en changeant, pour ce faire le pas du réseau de Bragg 108).

La couche absorbante 104 des sections absorbantes 96 et 98 a, de préférence, une largeur de bande interdite comprise entre la largeur de bande interdite de la couche 106 et la largeur de bande interdite de la couche 102.

Ceci présente l'avantage d'absorber plus efficacement la lumière de fuite.

Le dispositif conforme à l'invention, qui est schématiquement représenté sur la figure 5, constitue un duplexeur 1,3 μm - 1,5 μm en ligne.

Il s'agit d'un perfectionnement du dispositif de la figure 2.

Ce dispositif de la figure 5 comprend un moyen de réduction de la diaphotie qui se produit au niveau de la section de détection à 1,5 μm et qui est due à la lumière modulée de longueur d'onde 1,3 μm.

Ce moyen de réduction est constitué par une couche absorbant la lumière de longueur d'onde 1,3 μm, comme on le verra par la suite.

En revenant au dispositif représenté sur la figure 2, le signal optique incident à 1,5 μm est guidé par la couche active 60 du laser 51 à contre-réaction distribuée (émettant à 1,3 μm) et par la couche d'absorption à 1,3 μm qui prolonge cette couche active.

Ce signal optique est couplé d'une façon évanescente à la couche photodétectrice 68 destinée à détecter ce signal optique.

La section laser 51 et la section absorbante 54 sont réalisées en utilisant la même couche 60, active à 1,3 μm.

Dans un tel cas, la composition et l'épaisseur de cette couche 60 déterminent les caractéristiques du guidage à la fois à 1,3 μm et à 1,5 μm.

Pour obtenir un pouvoir d'absorption élevé de la section 54 absorbante à 1,3 μm et une insensibilité à la polarisation de la section de détection 52 (détectant la lumière modulée, de longueur d'onde 1,5 μm), une couche 60 épaisse est nécessaire mais pour obtenir une émission laser monomode à 1,3 μm (en mode transverse électrique), il faut que cette couche 60 ait une faible largeur, inférieure à 1 μm environ.

Il est extrêmement difficile de réaliser une telle couche avec une technique de gravure sèche.

L'utilisation de cette technique de gravure sèche impose le choix d'une couche 60 de faible épaisseur afin que le laser destiné à émettre à 1,3 μm soit monomode même si la largeur de la couche 60 est importante.

La diminution de l'épaisseur de cette couche réduit d'autant le pouvoir d'absorption à 1,3 μm et l'insensibilité de la détection à 1,5 μm du point de vue de la polarisation.

Pour résoudre ce problème, le dispositif conforme à l'invention, qui est schématiquement représenté sur la figure 5, comprend une couche absorbante supplémentaire 148 au-dessus de la couche de confinement 62.

Pour obtenir un pouvoir d'absorption élevé, la largeur de bande interdite de cette couche 148 doit être comprise entre 1,3 μm et 1,5 μm (ou, plus exactement, entre deux énergies de largeur de bande interdite qui correspondent respectivement aux longueurs d'onde 1,3 μm et 1,5 μm).

Afin d'éviter une absorption du signal optique incident à 1,5 μm que l'on veut détecter, il est préférable d'utiliser une couche dont la largeur de bande interdite vaut environ 1,45 µm.

On explique maintenant de façon plus précise la structure du dispositif de la figure 5.

Par souci de simplification, les éléments communs à ce dispositif de la figure 5 et au dispositif de la figure 2 ont les mêmes références.

On voit sur cette figure 5 que le dispositif qui y est représenté comprend une section absorbante supplémentaire, référencée 150, par rapport au dispositif de la figure 2.

Cette section absorbante supplémentaire 150 est comprise entre les sections 52 et 54 et comprend une couche conductrice 152 à sa partie supérieure (homologue de la couche conductrice 76 de la section absorbante 54).

La couche supplémentaire 148, qui est apte à absorber la lumière de longueur d'onde 1,3 µm, est situé au-dessus de la couche 62 et s'étend depuis l'extrémité du dispositif où se trouve la couche de haute réflectivité 84 jusqu'à l'endroit de la couche 62 où est formé le réseau 64, comme on le voit sur la figure 5.

La couche de faible épaisseur 66 est comprise entre la couche 62 et cette couche 148 et s'étend sur toute la longueur de cette couche 148.

La section de détection 52 et la section absorbante supplémentaire 150 sont traversées par cette couche 148 comme on le voit sur la figure 5 (mais elle ne traverse pas la section absorbante 54).

Une zone gravée supplémentaire 154 sépare la section absorbante supplémentaire 150 de la section de détection 52 et s'étend jusqu'à la couche 148 à travers les couches 72 et 70, comme on le voit sur la figure 5.

Une couche supplémentaire très mince 156, servant, comme la couche 66, à l'arrêt d'attaque chimique lors de la fabrication du dispositif, s'étend le long de la couche 68, entre cette couche 68 et la couche 148, comme on le voit sur la figure 5.

Un réseau de Bragg supplémentaire 158, destiné faire éventuellement fonctionner la section 52 en tant que laser de type DFB à 1,5 µm est formé sur une couche de confinement 159 qui s'étend le long de la couche 68, au-dessus de celle-ci, dans la section de détection 52, comme on le voit sur la figure 5.

Des moyens de polarisation 160 sont prévus pour appliquer une tension de polarisation négative à la couche conductrice 152 pour polariser la section absorbante en inverse.

Au lieu d'être placée au-dessus de la couche 62, la couche absorbante supplémentaire 148 pourrait être placée au-dessous mais le dispositif serait alors plus difficile à fabriquer.

De plus, on pourrait également munir un dispositif du genre de celui de la figure 1 d'une telle couche absorbante supplémentaire, selon le même principe.

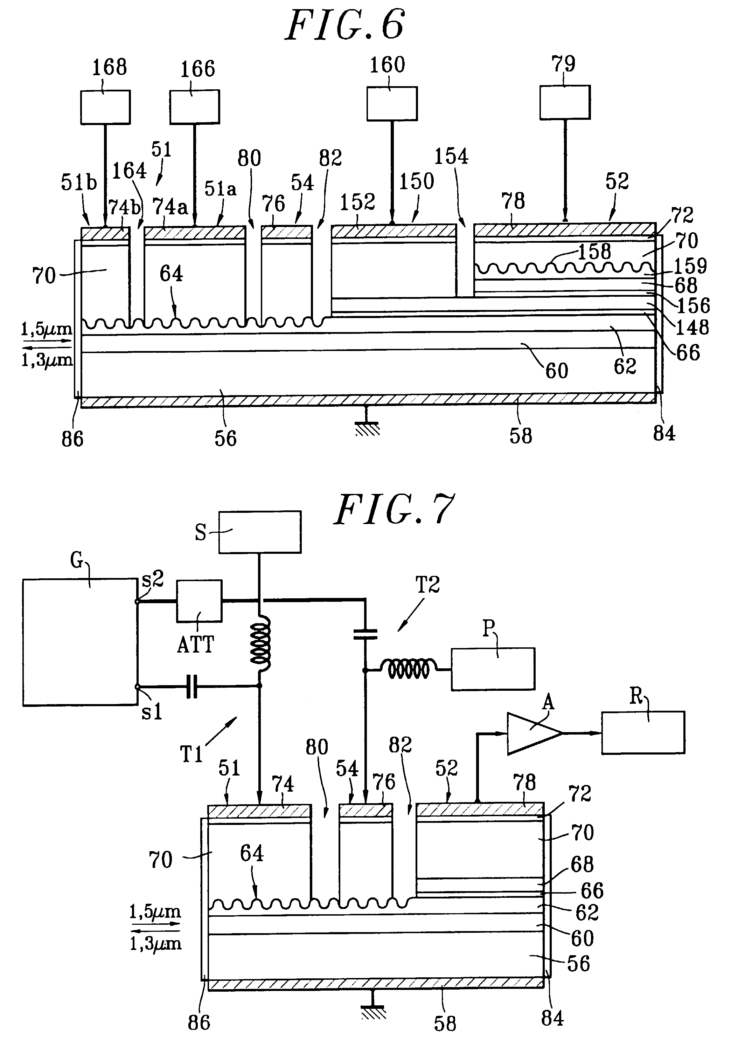

Le dispositif conforme à l'invention, qui est schématiquement représenté sur la figure 6, est un duplexeur 1,3-1,5 µm.

Ce duplexeur utilise également un couplage évanescent et comprend un modulateur à électro-absorption à 1,3 µm intégré.

Dans le dispositif de la figure 6, le moyen destiné à réduire fortement la diaphotie due à la lumière modulée de longueur d'onde 1,3 µm, au niveau de la section de photodétection, comprend à la fois la couche supplémentaire qui absorbe la lumière de longueur d'onde 1,3 µm et l'association d'un laser émettant en continu et d'un modulateur associé à ce laser.

On explique ci-après les différences entre le dispositif schématiquement représenté sur la figure 6 et celui qui est représenté par la figure 5.

Dans le cas du dispositif de la figure 6, le moyen de polarisation 77 est supprimé.

De plus, dans le dispositif de la figure 6, le composant intégré 54 constitue non plus une section absorbante mais un réflecteur de lumière de longueur d'onde 1,3 µm.

Dans le cas de la figure 6, le composant intégré 51 est subdivisé en deux composants référencés 51a et 51b qui sont séparés l'un de l'autre par une zone gravée 164.

Cette zone 164 s'étend jusqu'au réseau 64 à travers les couches 70 et 72, comme on le voit sur la figure 6.

Cette zone gravée 164 permet aussi la séparation électrique de l'électrode 74 de la figure 5 en deux électrodes 74a et 74b respectivement associées aux deux composants 51a et 51b, comme on le voit sur la figure 6.

Le composant 51a est compris entre le réflecteur 54 et le composant 51b.

Le composant 51a constitue un laser à contre-réaction distribuée qui est destiné à émettre en continu une lumière de longueur d'onde 1,3 µm et qui est muni, pour ce faire, de moyens de polarisation appropriés 166.

Le composant 51b constitue un modulateur à électro-absorption à 1,3 µm du type Franz-Keldysh qui est destiné à moduler la lumière émise par le laser 51a et qui est muni, pour ce faire, de moyens de polarisation appropriés 168.

Dans l'exemple de la figure 6

-    la couche 70 est en InP dopé P,
-    le substrat 56 est en InP dopé N,
-    la couche active 60 est en InGaAsP 1,3 µm,
-    la couche de contact 72 est en InGaAs,
-    le réseau 158, gravé sur la couche 159, est un réseau de Bragg dont la longueur d'onde de Bragg vaut 1,5 µm,
-    la couche 68 est une couche active en InGaAsP 1,5 µm,
-    les couches de confinement 62 et 159 sont en InGaAsP 1,18 µm, et
-    la couche absorbante 148, destinée à absorber la lumière de longueur d'onde 1,3 µm, est en InGaAsP 1,46 µm.

Le modulateur 51b est placé du côté de la face-avant du dispositif, devant la section laser 51a à 1,3 µm.

Dans le cas de ce dispositif de la figure 6, on dispose d'une section réflectrice, à savoir le réflecteur de lumière 54 (non polarisé) et d'une section absorbante (la section 150).

Le réflecteur 54 réfléchit la lumière de longueur d'onde 1,3 μm grâce au réseau de Bragg 64 et réduit considérablement la propagation de cette lumière vers la section de détection à 1,5 μm référencée 52.

Ce réflecteur 54 n'est pas polarisé afin d'augmenter le pouvoir de réflexion.

La section absorbante 150 est polarisée en inverse et absorbe la lumière à 1,3 μm.

Le pouvoir d'absorption de cette section 150 est renforcé grâce à la couche absorbante 148.

Du fait que le laser 51a n'est pas modulé, la lumière résiduelle de longueur d'onde 1,3 μm, qui est émise en direction de la section de photodétection 52, est essentiellement une lumière d'intensité constante.

On réduit ainsi de façon considérable la diaphotie due à cette lumière de longueur d'onde 1,3 μm.

Dans le modulateur 51b du type Franz-Keldysh, la polarisation en inverse de la couche modulante 60 en InGaAsP massif par les moyens de polarisation 168 induit une variation de l'absorption.

De préférence, afin de diminuer l'absorption de l'état passant du modulateur 51b, la longueur d'onde d'émission du laser 51a est choisie légèrement plus grande que celle correspondant au maximum du gain de la couche active 60.

Bien que la structure transversale du dispositif de la figure 6 (utilisation du matériau semi-isolant InP pour former les couches latérales ou utilisation d'une structure de type *"Buried Ridge Stripe"* pour réduire la capacité parasite et le courant de fuite traversant les homojonctions latérales) puisse intervenir d'une façon déterminante sur la performance finale de ce dispositif, cette structure n'est pas essentielle puisque la présente invention concerne la structure longitudinale du dispositif.

De la même façon, la méthode d'isolation électrique des différentes sections du dispositif de la figure 6 (par "découpage" des électrodes ou par implantation de protons par exemple) et la composition et l'empilement des matériaux utilisés pour former différentes couches (matériaux massifs ou matériaux à puits quantiques, qui déterminent également le type d'effet d'électro-absorption) ne sont pas essentiels.

Bien que cela ne fasse pas partie de la présente invention, il est à noter que le dispositif de la figure 6 pourrait être utilisé pour une émission à 1,5 μm et une réception à 1,3 μm.

Pour ce faire, il suffirait de polariser la section 52 de façon directe, cette section constituant alors un laser à contre-réaction distribuée, et de détecter les signaux de longueur d'onde 1,3 μm au niveau de la section de modulation 148b.

La figure 7 est une vue schématique d'un autre dispositif conforme à l'invention dans lequel le moyen de réduction de la diaphotie due à la lumière modulée de longueur d'onde 1,3 μm est un moyen de commande spécial de la section d'émission et de la section absorbante de ce dispositif.

Le dispositif de la figure 7 est identique au dispositif de la figure 2 excepté que les moyens de polarisation 75, 77 et 79 sont supprimés et remplacés par d'autres moyens que l'on va décrire.

Dans le cas de la figure 7, pour réduire, voire annuler, la diaphotie due au laser 51, on applique deux signaux complémentaires l'un de l'autre respectivement à ce laser 51 et à la section absorbante 54.

En effet, la lumière modulée de longueur d'onde 1,3 μm qui se propage vers la photodiode 52 (qui est destinée à détecter les signaux de longueur d'onde 1,5 μm), peut être supprimée en faisant varier le taux d'absorption de la section absorbante en opposition de phase par rapport à la modulation de cette lumière.

Une telle façon de procéder est plus simple et plus facile à mettre en oeuvre que l'utilisation d'un amplificateur différentiel après la détection et la pré-amplification des signaux de longueur d'onde 1,5 μm.

Les moyens de commande que comprend le dispositif de la figure 7 et qui permettent le fonctionnement de celui-ci comprennent un générateur G ayant deux sorties s1 et s2 et apte à fournir respectivement sur ces deux sorties s1 et s2 deux signaux électriques D et $\bar{D}$ qui sont complémentaires l'un de l'autre.

Ces moyens de commande comprennent également un Té de polarisation référencé T1, qui est relié d'une part à la sortie s1 et d'autre part à une source de courant S en vue de l'alimentation du laser 51, comme on le voit sur la figure 7.

Ces moyens de fonctionnement comprennent aussi un autre Té de polarisation référencé T2, qui est relié d'une part à la sortie s2 par l'intermédiaire d'un atténuateur variable ATT et d'autre part à une source de tension négative référencée P pour polariser en inverse la section absorbante 54, comme on le voit sur la figure 7.

L'électrode 78 de la section de photodétection 52 est, quant à elle, reliée à des moyens R de traitement du signal reçu, de longueur d'onde 1,5 μm, par l'intermédiaire d'un amplificateur de haute fréquence A, comme on le voit sur la figure 7.

Dans le cas du dispositif de la figure 7, la section de photodétection 52 n'est pas polarisée mais elle pourrait fonctionner en étant polarisée en inverse.

Le laser 57 est modulé par le signal D.

La section absorbante 54 est polarisée en inverse et modulée par le signal complémentaire $\bar{D}$ dont l'amplitude est ajustée afin d'annuler la modulation de la lumière se propageant vers la photodiode 52.

L'atténuateur variable ATT est utilisé pour ajuster cette amplitude appliquée à la section absorbante 54.

Le Té de polarisation T1 est utilisé pour éviter la perturbation de la source S par le signal provenant de la sortie sl.

Le Té de polarisation T2 est utilisé pour éviter la perturbation de la source P par le signal provenant de la sortie s2.

L'amplificateur de haute fréquence A sert à augmenter le niveau du signal de longueur d'onde 1,5 μm.

Dans l'exemple de la figure 7, le duplexeur comprend trois sections 51, 52 et 54.

Le mode de réalisation de l'invention utilisant deux signaux complémentaires l'un de l'autre pourrait bien entendu être appliqué à un duplexeur conforme à l'invention ayant plus de trois sections (c'est-à-dire plus d'une section absorbante).

Les documents cités dans la présente description sont les suivants :

(1) P.J. Williams, R.G. Walker, P.M. Charles, R. Ogden, R.H. Lord, F.A. Randle, G.M. Foster, I. Bennion and A.C. Carter, " Design and fabrication of transceiver modules featuring monolithic optoelectronic integrated circuits for TPON/BPON access networks ", OFC' 91, San Jose (USA), paper PD11-1, 1991

(2) T.L. Koch and U. Koren, " Semiconductor photonic integrated circuits ", IEEE J. Quantum Electron., 27, pp.641-653 (1991)

(3) J. Charil, S. Slempkes, D. Robein, C. Kazmierski and J.C. Bouley, " Extremely low threshold operation of 1.5 μm GaInAsP/InP buried ridge stripe lasers ", Electron. Lett. 25, pp.1477-1479 (1989)

## Revendications

1. Dispositif semiconducteur d'émission-réception de signaux optiques modulés, ce dispositif étant caractérisé en ce qu'il comprend un substrat semiconducteur (90; 56) sur lequel sont intégrés de façon monolithique :

   - un premier composant semiconducteur (92; 51) ayant une couche active à la longueur d'onde λ1, ce premier composant étant apte à émettre une lumière modulée de longueur d'onde λ1,
   - un deuxième composant semiconducteur (94; 52) ayant une couche active à une longueur d'onde λ2, cette longueur d'onde λ2 étant supérieure à la longueur d'onde λ1, ce deuxième composant étant apte à détecter une lumière modulée de longueur d'onde λ2, et
   - au moins un troisième composant semiconducteur (96, 98; 54, 150; 54) qui sépare les premier et deuxième composants l'un de l'autre et qui est apte à absorber la lumière de longueur d'onde λ1 sans absorber la lumière de longueur d'onde λ2,

   et en ce qu'au moins l'un des premier, deuxième et troisième composants est conçu pour réduire la diaphotie qui se produit au niveau du deuxième composant et qui est due à la lumière modulée de longueur d'onde λ1 provenant du premier composant.

2. Dispositif selon la revendication 1, caractérisé en ce que le premier composant comprend :

   - un laser (92b) qui est apte à émettre une lumière de longueur d'onde λ1 et d'intensité constante, et
   - un moyen (92a) de modulation de la lumière de longueur d'onde λ1 émise par le laser, ce laser étant placé entre ce moyen de modulation et le troisième composant (96, 98).

3. Dispositif selon la revendication 2, caractérisé en ce que le laser (92b) apte à émettre la lumière de longueur d'onde λ1 et d'intensité constante est un laser à contre-réaction distribuée.

4. Dispositif selon l'une quelconque des revendications 2 et 3, caractérisé en ce que le moyen de modulation de lumière (92a) est un modulateur d'intensité qui est électro-absorbant à la longueur d'onde λ1.

5. Dispositif selon l'une quelconque des revendications 2 à 4, caractérisé en ce que le troisième composant comprend une couche absorbant la lumière, dont la largeur de bande interdite est comprise entre la largeur de bande interdite de la couche active du premier composant et la largeur de bande interdite de la couche active du deuxième composant.

6. Dispositif selon l'une quelconque des revendications 1 à 5, caractérisé en ce qu'il comprend en outre, au moins au niveau du deuxième composant (52), une couche absorbante supplémentaire (148), apte à absorber la lumière de longueur d'onde λ1.

7. Dispositif selon la revendication 6, caractérisé en ce que la couche (60) active à la longueur d'onde λ1 du premier composant se prolonge dans le troisième composant et dans le deuxième composant, en ce que le dispositif comprend en outre une couche de confinement de lumière (62) qui s'étend le long de cette couche active à la longueur d'onde λ1 et qui, dans le deuxième composant, est comprise entre cette couche active à la longueur d'onde λ1 et la couche (68) active à la longueur d'onde λ2, et en ce que la couche absorbante supplémentaire (148) se trouve, dans le deuxième composant, entre la couche de confinement (62) et la couche (68) active à la longueur d'onde λ2.

8. Dispositif selon l'une quelconque des revendications 6 et 7, caractérisé en ce que la couche absorbante supplémentaire (148) se prolonge dans le troisième composant (150).

9. Dispositif selon l'une quelconque des revendications 6 à 8, caractérisé en ce que la largeur de bande interdite de la couche absorbante supplémentaire (148) est comprise entre la largeur de bande interdite de la couche (60) active à la longueur d'onde λ1 et la largeur de bande interdite de la couche (68) active à la longueur d'onde λ2.

10. Dispositif selon la revendication 1, caractérisé en ce les premier et troisième composants sont munis de moyens de commande prévus pour appliquer au premier composant (51) des premiers signaux électriques (s1) permettant la production de la lumière modulée à la longueur d'onde λ1 et pour appliquer au troisième composant (54) des deuxièmes signaux électriques (s2) qui sont complémentaires des premiers signaux électriques de façon que la modulation du premier composant par les premiers signaux électriques et la modulation du troisième composant par les deuxièmes signaux électriques se fassent en opposition de phase.

11. Dispositif selon l'une quelconque des revendications 1 à 10, caractérisé en ce que la longueur d'onde λ1 vaut 1,3 µm et la longueur d'onde λ2 vaut 1,5 µm.

*FIG.1*

*FIG.2*

*FIG.3*

*FIG.4*

*FIG.5*

## FIG.6

## FIG.7

Office européen
des brevets

**RAPPORT DE RECHERCHE EUROPEENNE**

Numero de la demande

EP 97 40 0528

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | US 5 031 188 A (KOCH THOMAS L  ET AL) 9 juillet 1991<br>* figure 5 *<br>--- | 1-6,10 | H01L27/15 |
| A | US 4 860 294 A (WINZER GERHARD  ET AL) 22 août 1989<br>* le document en entier *<br>--- | 1-11 | |
| A | GB 2 243 720 A (AMERICAN TELEPHONE & TELEGRAPH) 6 novembre 1991<br>* le document en entier *<br>--- | 1-11 | |
| A | EP 0 527 060 A (THOMSON CSF) 10 février 1993<br>* le document en entier *<br>--- | 1-11 | |
| A,D | ELECTRONICS LETTERS,<br>vol. 26, no. 22, 26 octobre 1989,<br>pages 1477-1479, XP000076290<br>CHARIL J ET AL:  "EXTREMELY LOW THRESHOLD OPERATION OF 1.5 M GAINASP/INP BURIED RIDGE STRIPE LASERS"<br>* le document en entier *<br>--- | 1-11 | **DOMAINES TECHNIQUES RECHERCHES (Int.Cl.6)**<br><br>H01L |
| A,D | IEEE JOURNAL OF QUANTUM ELECTRONICS,<br>vol. 27, no. 3, 1 mars 1991,<br>pages 641-653, XP000227520<br>KOCH T L ET AL:  "SEMICONDUCTOR PHOTONIC INTEGRATED CIRCUITS"<br>* le document en entier *<br>--- | 1-11 | |

-/--

Le présent rapport a été établi pour toutes les revendications

| Lieu de la recherche | Date d'achèvement de la recherche | Examinateur |
|---|---|---|
| LA HAYE | 25 juin 1997 | Lina, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

**Office européen des brevets**

**RAPPORT DE RECHERCHE EUROPEENNE**

Numero de la demande
EP 97 40 0528

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A,D | ELECTRONICS LETTERS, vol. 27, no. 10, 9 mai 1991, pages 809-810, XP000212340 WILLIAMS P J ET AL: "DESIGN AND FABRICATION OF MONOLITHICALLY INTEGRATED DFB LASER-WAVELENGTH DUPLEXER TRANSCEIVERS FOR TPON/BPON ACCESS LINKS" * le document en entier * ----- | 1-11 | |

DOMAINES TECHNIQUES RECHERCHES (Int.Cl.6)

Le présent rapport a été établi pour toutes les revendications

| Lieu de la recherche | Date d'achèvement de la recherche | Examinateur |
|---|---|---|
| LA HAYE | 25 juin 1997 | Lina, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)